# EUROPÄISCHE PATENTSCHRIFT

(11) **EP 2 659 525 B1**
(45) Veröffentlichungstag und Bekanntmachung des Hinweises auf die Patenterteilung: **12.07.2017**
(21) Anmeldenummer: 12721252.0
(22) Anmeldetag: 09.05.2012
(51) Int. Cl.: C09K 11/02, C09K 11/59, C09K 11/64, C09K 11/77, H01L 33/50

(54) **KONVERSIONSELEMENT UND LEUCHTDIODE MIT EINEM SOLCHEN KONVERSIONSELEMENT**
CONVERSION ELEMENT AND A LIGHT-EMITTING DIODE COMPRISING SUCH A CONVERSION ELEMENT
ÉLÉMENT DE CONVERSION ET DIODE ÉLECTROLUMINESCENTE DOTÉE D'UN TEL ÉLÉMENT DE CONVERSION

(30) Priorität: 30.06.2011 DE 102011078402
(43) Veröffentlichungstag der Anmeldung: 06.11.2013
(73) Patentinhaber: OSRAM Opto Semiconductors GmbH, 93055 Regensburg (DE)
(72) Erfinder: WINDISCH, Reiner, 93186 Pettendorf (DE)
(86) Internationale Anmeldenummer: PCT/EP2012/058548
(87) Internationale Veröffentlichungsnummer: WO 2013/000615

(56) Entgegenhaltungen:
- DE-A1-102008 021 662
- DE-A1-102009 037 730
- DE-A1-102009 037 732
- US-A1- 2010 142 189

## Beschreibung

Es wird ein Konversionselement angegeben.

Die Druckschrift DE 10 2009 037 730 A1 offenbart eine Konversions-LED die eine Leuchtstoffmischung aufweist, mit einem ersten Leuchtstoff vom Typ LuAGaG und einem zweiten Leuchtstoff vom Typ Calsin. Mit der Konversions-LED wird eine sehr hohe Farbwidergabe erzielt.

Die Druckschrift DE 10 2009 037 732 A1 offenbart eine Konversions-LED die eine Leuchtstoffmischung aufweist, mit einem ersten Leuchtstoff vom Typ LuAGaG und einem zweiten Leuchtstoff vom Typ Nitridosilikat. Mit der Konversions-LED wird eine sehr hohe Effizienz erzielt.

Die Druckschrift DE 10 2008 021 662 A1 offenbart ein LED-Modul aufweisend mindestens eine blaue LED und eine darauf aufgebrachte Farbkonversionsschicht. Die Farbkonversionsschicht weist mindestens drei unterschiedliche Leuchtstoffe auf, welche das Licht der blauen LED zumindest teilweise in rotes, grünes und gelbes bzw. gelbgrünes Licht konvertiert. Der Leuchtstoff zur Konversion in rotes Licht ist eine dotierte Nitrid-Verbindung, vorzugsweise ein Nitridosilkat.

Die Druckschrift US2010/0142189 A1 offenbart eine LED-Vorrichtung, die eine sehr hohe Farbwidergabe erzielt. Die LED-Vorrichtung umfasst eine im blauen oder im ultravioletten Bereich emittierende Halbleitervorrichtung sowie Leuchtstoffe. Die Leuchtstoffe umfassen einen grün emittierenden Leuchtstoff und einen rot emittierenden Leuchtstoff.

Eine zu lösende Aufgabe besteht darin, ein Konversionselement anzugeben, das eine verbesserte Effizienz aufweist. Eine weitere zu lösende Aufgabe besteht darin, ein Konversionselement anzugeben, mit dem Licht mit verbesserter Temperaturstabilität des Farborts erzeugt werden kann.

Gemäß der Erfindung ist das Konversionselement dazu geeignet, elektromagnetische Strahlung aus einem ersten Wellenlängenbereich zu elektromagnetischer Strahlung aus einem zweiten Wellenlängenbereich, der größere Wellenlängen als der erste Wellenlängenbereich umfasst, zu konvertieren. Das heißt, das Konversionselement ist zur so genannten "dorn Konversion" von elektromagnetischer Strahlung vorgesehen. Beispielsweise konvertiert das Konversionselement zumindest einen Teil einer Primärstrahlung, zum Beispiel blaues Licht, zu einer Sekundärstrahlung, zum Beispiel rotes, grünes und/oder gelbes Licht. Insgesamt kann vom Konversionselement dann Mischstrahlung ausgesendet werden, die sich aus der elektromagnetischen Strahlung aus dem ersten und dem zweiten Wellenlängenbereich zusammensetzt.

Das Konversionselement kann als selbsttragende Platte, die beispielsweise quaderförmig sein kann, als flexible Folie oder als Vergussmaterial ausgebildet sein. Das Konversionselement ist dazu geeignet, einem strahlungsemittierenden Bauelement, insbesondere einem Leuchtdiodenchip, nachgeordnet zu werden. Das Konversionselement konvertiert dann die vom strahlungsemittierenden Bauelement im Betrieb erzeugte elektromagnetische Strahlung aus dem ersten Wellenlängenbereich zumindest teilweise zu elektromagnetischer Strahlung aus dem zweiten Wellenlängenbereich.

Gemäß zumindest einer Ausführungsform des Konversionselements umfasst das Konversionselement ein Matrixmaterial. Bei dem Matrixmaterial handelt es sich um ein für die elektromagnetische Strahlung aus dem ersten Wellenlängenbereich und elektromagnetische Strahlung aus dem zweiten Wellenlängenbereich durchlässiges Material, das beispielsweise für elektromagnetische Strahlung aus diesen Wellenlängenbereichen klarsichtig ausgebildet sein kann. Das Matrixmaterial weist einen optischen Brechungsindex auf, der temperaturabhängig ist. Insbesondere ist der Brechungsindex in einem Temperaturbereich von zirka 20 °C bis zirka 200 °C temperaturabhängig. Beispielsweise nimmt der optische Brechungsindex in diesem Temperaturbereich mit steigenden Temperaturen ab. Bei dem Matrixmaterial kann es sich beispielsweise um ein Silikon oder ein Epoxidharz handeln. Ferner ist es möglich, dass es sich bei dem Matrixmaterial um eine Mischung aus Silikon und Epoxidharz handelt.

Gemäß zumindest einer Ausführungsform des Konversionselements umfasst das Konversionselement zumindest zwei unterschiedliche Arten von Leuchtstoffpartikeln, wobei eine Vielzahl von Leuchtstoffpartikeln jeder dieser Arten im Matrixmaterial verteilt ist. Das Matrixmaterial umgibt die Leuchtstoffpartikel, die in ihm verteilt sind, beispielsweise formschlüssig. Das heißt, die Leuchtstoffpartikel können in das Matrixmaterial eingebettet sein. Dabei ist es möglich, dass die Leuchtstoffpartikel der unterschiedlichen Arten zufällig und möglichst gleichmäßig im Matrixmaterial verteilt sind. Darüber hinaus ist es auch möglich, dass es an bestimmten Stellen des Matrixmaterials zu einer Häufung von Leuchtstoffpartikeln kommt, die beispielsweise durch ein Absinken der Leuchtstoffpartikel im Matrixmaterial zustande kommt.

Gemäß zumindest einer Ausführungsform des Konversionselements unterscheiden sich Leuchtstoffpartikel unterschiedlicher Arten durch zumindest eine der folgenden Eigenschaften: die mittlere Partikelgröße und/oder das Material. Dabei ist es auch möglich, dass sich die unterschiedlichen Arten von Leuchtstoffpartikeln durch beide Eigenschaften voneinander unterscheiden. Das heißt, die Leuchtstoffpartikel unterschiedlicher Arten können mit unterschiedlichen Lumineszenzkonversionsmaterialien gebildet sein und/oder im Mittel unterschiedliche Größen aufweisen. Dadurch weisen die Leuchtstoffpartikel unterschiedlicher Arten beispielsweise voneinander unterschiedliche Emissionswellenlängen und/oder unterschiedliche Streuverhalten auf.

Gemäß zumindest einer Ausführungsform des Konversionselements emittiert das Konversionselement bei Anregung durch elektromagnetische Strahlung aus dem ersten Wellenlängenbereich Mischstrahlung mit elektromagnetischer Strahlung aus dem ersten und dem zweiten Wellenlängenbereich. Das heißt, zumindest ein Teil der in das Konversionselement eintretenden elektromagnetischen Strahlung aus dem ersten Wellenlängenbereich wird nicht konvertiert, sondern verlässt das Konversionselement unkonvertiert, sodass vom Konversionselement aus Mischstrahlung aus konvertierter und unkonvertierter elektromagnetischer Strahlung austritt. Beispielsweise handelt es sich bei dieser Mischstrahlung um weißes oder farbiges Licht.

Gemäß zumindest einer Ausführungsform des Konversionselements bleiben die korrelierte Farbtemperatur und/oder der Farbort der Mischstrahlung bei einer Temperatur des Matrixmaterials zwischen 20 °C und 200 °C, insbesondere zwischen 25 °C und 150 °C, im Wesentlichen gleich. "Im Wesentlichen gleich" heißt dabei beispielsweise, dass ein durchschnittlicher Betrachter der Mischstrahlung bei einer Temperaturänderung im genannten Temperaturbereich keine Änderung an der korrelierten Farbtemperatur und/oder dem Farbort mit bloßem Auge feststellen kann. Dem Betrachter erscheint die emittierte Mischstrahlung also auch bei Temperaturschwankungen hinsichtlich Farbtemperatur und/oder Farbort als konstant.

Gemäß der Erfindung umfasst das Konversionselement ein Matrixmaterial, dessen optischer Brechungsindex temperaturabhängig ist und zumindest zwei unterschiedliche Arten von Leuchtstoffpartikeln, wobei eine Vielzahl von Leuchtstoffpartikeln einer jeder der Arten im Matrixmaterial verteilt ist, Leuchtstoffpartikel unterschiedlicher Art sich durch mittlere Partikelgröße und/oder Material voneinander unterscheiden, das Konversionselement bei Anregung durch elektromagnetische Strahlung aus dem ersten Wellenlängenbereich Mischstrahlung mit elektromagnetischer Strahlung aus dem ersten und zweiten Wellenlängenbereich emittiert, und die korrelierte Farbtemperatur und/oder der Farbort der Mischstrahlung bei einer Temperatur des Matrixmaterials zwischen 25 °C und 150 °C im Wesentlichen gleich bleiben.

Einem hier beschriebenen Konversionselement liegen dabei unter anderem die folgenden Überlegungen zugrunde:
Im Betrieb eines optoelektronischen Bauelements, dem ein Konversionselement nachgeordnet ist, ändert sich die Temperatur des Konversionselements durch Erwärmung des Konversionselements aufgrund von Abwärme des optoelektronischen Bauelements und/oder Konversionsverlusten. Die Änderung der Temperatur des Konversionselements führt in der Regel zu einer Änderung des Farborts und damit auch zu einer Änderung der korrelierten Farbtemperatur des vom Konversionselement emittierten Mischlichts. Dies ist beispielsweise beim Einsatz des Konversionselements in der Allgemeinbeleuchtung unerwünscht, da sich hierdurch je nach Umgebungstemperatur und je nach Betriebsdauer des optoelektronischen Bauelements der Farbeindruck des erzeugten Lichts ändern kann, was vom Betrachter als unangenehm wahrgenommen wird.

Ursache für die Verschiebung des Farborts ist ein Zusammenwirken vieler physikalischer Prozesse wie beispielsweise:
- die temperaturabhängige Verschiebung der vom optoelektronischen Bauelement erzeugten elektromagnetischen Strahlung aus dem ersten Wellenlängenbereich,
- die Temperaturabhängigkeit der Quanteneffizienz der Leuchtstoff-Konversion,
- die Temperaturabhängigkeit der Leuchtstoffabsorption,
- die Temperaturabhängigkeit des Leuchtstoff-Emissionsspektrums,
- die Temperaturabhängigkeit der Lichtstreuung im Konversionselement aufgrund der Temperaturabhängigkeit des Brechungsindexes des Matrixmaterials des Konversionselements.

Insbesondere bei Konversionselementen, welche Partikel von Leuchtstoffen in dem Matrixmaterial enthalten, spielt die Brechungsindexänderung des Matrixmaterials mit der Temperatur eine wichtige Rolle. Beispielsweise sinkt mit steigender Temperatur des Matrixmaterials der Brechungsindex ab, wodurch sich in der Regel die Lichtstreuung an den Leuchtstoffpartikeln, die im Matrixmaterial eingebracht sind, erhöht, da sich der Brechungsindexunterschied zwischen den Leuchtstoffpartikeln und dem Matrixmaterial erhöht. Eine Erhöhung der Streuung führt zu einer Verlängerung des mittleren Laufwegs der elektromagnetischen Strahlung aus dem ersten Wellenlängenbereich im Konversionselement und damit zu einer Erhöhung der Absorption von elektromagnetischer Strahlung aus dem ersten Wellenlängenbereich. Auf diese Weise erhöht sich also die Wahrscheinlichkeit für eine Konversion durch Leuchtstoffpartikel des Konversionselements, was zu einer Farbortverschiebung in Konversionsrichtung führt.

Da die ersten drei der oben genannten Prozesse in aller Regel zu einer Farbortverschiebung in Richtung der elektromagnetischen Strahlung aus dem ersten Wellenlängenbereich führen, bewirkt die Brechungsindexänderung eine teilweise Kompensation dieser Farbortverschiebung. Wie stark diese Kompensation ausfällt, hängt von den Eigenschaften der verwendeten Leuchtstoffpartikel, insbesondere von deren Brechungsindex und der Partikelgrößenverteilung sowie vom verwendeten Matrixmaterial ab. Bisher wurde festgestellt, dass die Kompensation in der Regel jedoch zu gering ist, um die Verschiebung in Richtung der elektromagnetischen Strahlung aus dem ersten Wellenlängenbereich, also beispielsweise in Richtung blau, nennenswert zu verändern.

Eine Lösung dieses Problems könnte darin bestehen, zusätzliche, nicht konvertierende Streupartikel, aus einem Material, dessen Brechungsindex entweder bei Raumtemperatur oder bei der typischen Betriebstemperatur möglichst nahe am Brechungsindex des Matrixmaterials liegt, dem Matrixmaterial beizumischen. Diese Streupartikel sorgen dann unter Ausnutzung der temperaturabhängigen Brechungsindexänderung des Matrixmaterials für zusätzliche oder reduzierte Streuung, abhängig von der Temperatur, und können auf diese Weise den Farbort der emittierten Mischstrahlung stabilisieren. Damit ist jedoch eine Reduzierung der Effizienz aufgrund zusätzlicher Streuverluste an den Streupartikeln verbunden, zumindest bei den Temperaturen des Matrixmaterials, bei denen der Brechungsindex von Streupartikeln und Matrixmaterial nicht identisch sind.

Vorliegend wird daher unter anderem vorgeschlagen, im Konversionselement eine Mischung unterschiedlicher Leuchtstoffarten zu verwenden, deren Mischung gezielt derart optimiert ist, dass eine Stabilisierung von Farbtemperatur und/oder Farbort über einen großen Temperaturbereich eintritt. Dabei ist jedoch zu beachten, dass der Brechungsindex von Leuchtstoffpartikeln nicht frei wählbar ist, da er durch das Material der Leuchtstoffpartikel gegeben ist, dessen Wahl wiederum von der beabsichtigten Emissionswellenlänge der Leuchtstoffpartikel bestimmt wird.

Einem hier beschriebenen Konversionselement liegt unter anderem die Idee zugrunde, zumindest zwei Leuchtstoffe unterschiedlicher Art derart zu mischen, dass der Farbort bei einer Änderung der Temperatur in einem weiteren Temperaturbereich nahezu konstant bleibt beziehungsweise die korrelierte Farbtemperatur sich in einem weiten Temperaturbereich nicht ändert. Dies kann durch die Verwendung von wenigstens zwei unterschiedlichen Arten von Leuchtstoffen erreicht werden, wobei bei einem der beschriebenen Leuchtstoffe die Kompensation der Verschiebung hin zu elektromagnetischer Strahlung aus dem ersten Wellenlängenbereich zu gering ausfällt und bei der zweiten Art von Leuchtstoffen eine Überkompensation auftritt, das heißt für Partikel dieses Leuchtstoffes würde sich die Mischstrahlung in Richtung der elektromagnetischen Strahlung aus dem zweiten Wellenlängenbereich verschieben.

Gemäß der Erfindung variiert die korrelierte Farbtemperatur der Mischstrahlung bei einer Temperatur des Matrixmaterials zwischen 25 °C und 150 °C um höchstens 60 K. Das heißt, die korrelierte Farbtemperatur bleibt in diesem Temperaturbereich des Matrixmaterials weitgehend stabil.

Gemäß zumindest einer Ausführungsform des Konversionselements liegt der Farbort der Mischstrahlung bei einer Temperatur des Matrixmaterials zwischen 25 °C und 150 °C innerhalb einer Drei-Step-McAdam-Ellipse. Insbesondere ist es möglich, dass der Farbort der Mischstrahlung im genannten Temperaturbereich innerhalb einer Ein-Step-McAdam-Ellipse liegt. Die genannten Farbortverschiebungen sind dabei vom menschlichen Betrachter kaum oder gar nicht wahrnehmbar.

Gemäß zumindest einer Ausführungsform des Konversionselements sinkt der Brechungsindex des Matrixmaterials in einem Temperaturbereich zwischen 25 °C und 150 °C mit steigender Temperatur des Matrixmaterials. Beispielsweise trifft dies auf ein Matrixmaterial zu, das mit einem Silikon gebildet ist oder aus einem Silikon besteht.

Gemäß zumindest einer Ausführungsform des Konversionselements ist das Matrixmaterial im Wesentlichen frei von Partikeln eines Streumaterials. Unter einem Streumaterial wird dabei ein Material ohne Wellenlängen konvertierende Eigenschaften verstanden. "Im Wesentlichen frei" heißt, dass die Konzentration an Partikeln eines Streumaterials, die beispielsweise als Rückstände aus der Herstellung der Leuchtstoffpartikel im Matrixmaterial vorhanden sein können, höchstens 0,1 Gew.-% am Gesamtgewicht des Konversionselements beträgt. Mit anderen Worten ist ein Streumaterial nicht gezielt in das Matrixmaterial des Konversionselements eingebracht.

Gemäß zumindest einer Ausführungsform des Konversionselements umfasst das Konversionselement drei Arten von Leuchtstoffpartikeln, wobei zwei Arten von Leuchtstoffpartikeln einen gleichen oder ähnlichen ersten Emissions-Wellenlängenbereich aufweisen. Das heißt, zwei Arten von Leuchtstoffpartikeln weisen einen Emissions-Wellenlängenbereich auf, bei dem sich das Maximum der Emissionswellenlänge um weniger als 60 nm, insbesondere um weniger als 50 nm voneinander unterscheidet. Die beiden Arten von Leuchtstoffpartikeln re-emittieren dann insbesondere Licht der gleichen Farbe. Bei Betrachtung der dominanten Wellenlänge beträgt der Unterschied der Emissionsmaxima der beiden Arten von Leuchtstoffpartikeln vorzugsweise höchstens 30 nm, insbesondere höchstens 20 nm. Ferner ist es möglich, dass die Leuchtstoffpartikel unterschiedlicher Art mit dem gleichen Material gebildet sind und von daher einen gleichen Emissions-Wellenlängenbereich aufweisen.

Gemäß dieser Ausführungsform kann das Konversionselement eine dritte Art von Leuchtstoffpartikeln umfassen, die einen weiteren Emissions-Wellenlängenbereich aufweist, dessen Maximum vom Maximum des ersten Emissions-Wellenlängenbereichs um wenigstens 100 nm, insbesondere um wenigstens 150 nm, abweicht.

Mit anderen Worten emittieren die Leuchtstoffpartikel der dritten Art Licht einer anderen Farbe als die Leuchtstoffpartikel der ersten und der zweiten Art.

Gemäß zumindest einer Ausführungsform des Konversionselements bestehen die Leuchtstoffpartikel von zumindest zwei der unterschiedlichen Arten aus unterschiedlichen Materialien und weisen einen ähnlichen Emissions-Wellenlängenbereich auf.

Beispielsweise kann das Konversionselement drei Arten von Leuchtstoffpartikeln aus den folgenden Materialien umfassen: LuAGaG:Ce als Leuchtstoffpartikel, die grünes Licht re-emittieren, (Sr,Ca,Ba)₂Si₅N₈ als Leuchtstoffpartikel, die rotes Licht emittieren und CaAlSiN ebenfalls als Leuchtstoffpartikel, die rotes Licht emittieren. Für die letztgenannten Leuchtstoffpartikel ergibt sich die oben beschriebene Überkompensation, während die zweitgenannten Leuchtstoffpartikel keine ausreichende Kompensation der Farbortverschiebung durch eine Änderung der Streuung ermöglichen. In der Mischung der drei genannten Arten von Leuchtstoffpartikeln im gemeinsamen Matrixmaterial, das beispielsweise mit Silikon gebildet ist, ergibt sich eine nahezu konstante Farbtemperatur im oben genannten Temperaturbereich.

Gemäß zumindest einer Ausführungsform des Konversionselements sind die Leuchtstoffpartikel von zumindest zwei der unterschiedlichen Arten von Leuchtstoffpartikeln aus dem gleichen Material gebildet und unterscheiden sich hinsichtlich ihrer mittleren Partikelgröße. In diesem Fall ist die Streuwirkung bei unterschiedlichen Temperaturen durch die unterschiedlichen Partikelgrößen bestimmt. Durch die Mischung von Leuchtstoffpartikeln mit unterschiedlichen mittleren Partikelgrößen können die Streueigenschaften für elektromagnetische Strahlung aus dem ersten Wellenlängenbereich, die in das Konversionselement eintritt, gezielt eingestellt werden.

Es wird darüber hinaus eine Leuchtdiode angegeben. Bei der Leuchtdiode kann ein hier beschriebenes Konversionselement Verwendung finden. Das heißt, sämtliche für das Konversionselement beschriebenen Merkmale sind auch für die Leuchtdiode beschrieben.

Gemäß zumindest einer Ausführungsform der Leuchtdiode umfasst die Leuchtdiode zumindest einen Leuchtdiodenchip, der im Betrieb elektromagnetische Strahlung aus dem ersten Wellenlängenbereich emittiert. Dabei handelt es sich beispielsweise um blaues Licht. Ferner umfasst die Leuchtdiode ein hier beschriebenes Konversionselement, das dem Leuchtdiodenchip derart nachgeordnet ist, dass zumindest ein Teil der elektromagnetischen Strahlung aus dem ersten Wellenlängenbereich in das Konversionselement tritt und zu elektromagnetischer Strahlung aus dem zweiten Wellenlängenbereich konvertiert wird. Die elektromagnetische Strahlung aus den beiden Wellenlängenbereichen mischt sich dann zu Mischstrahlung, bei der es sich beispielsweise um weißes Licht handeln kann. Das Konversionselement kann dabei als dünne Schicht auf eine Strahlungsaustrittsfläche des Leuchtdiodenchips aufgebracht werden. Ferner ist es möglich, dass ein vorgefertigtes Konversionselement, beispielsweise in Form eines Plättchens oder einer Folie, auf die Strahlungsaustrittsfläche des Leuchtdiodenchips aufgebracht wird. Darüber hinaus ist es möglich, dass das Konversionselement den Leuchtdiodenchip formschlüssig umhüllt. In diesem Fall ist das Konversionselement beispielsweise nach Art eines Vergussmaterials durch Spritzgießen oder Spritzpressen auf den Leuchtdiodenchip aufgebracht.

Im Folgenden werden ein hier beschriebenes Konversionselement sowie ein hier beschriebener Leuchtdiodenchip anhand von Ausführungsbeispielen und den dazugehörigen Figuren näher erläutert.
Die Figur 1 zeigt anhand einer schematischen Schnittdarstellung ein Ausführungsbeispiel eines hier beschriebenen Konversionselements.
Die Figur 2 zeigt anhand einer schematischen Schnittdarstellung ein Ausführungsbeispiel einer hier beschriebenen Leuchtdiode.
Die Figuren 3 und 4 zeigen anhand grafischer Auftragungen Eigenschaften von hier beschriebenen Konversionselementen und Leuchtdioden.

Gleiche, gleichartige oder gleich wirkende Elemente sind in den Figuren mit den gleichen Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder für eine bessere Verständlichkeit übertrieben groß dargestellt sein.

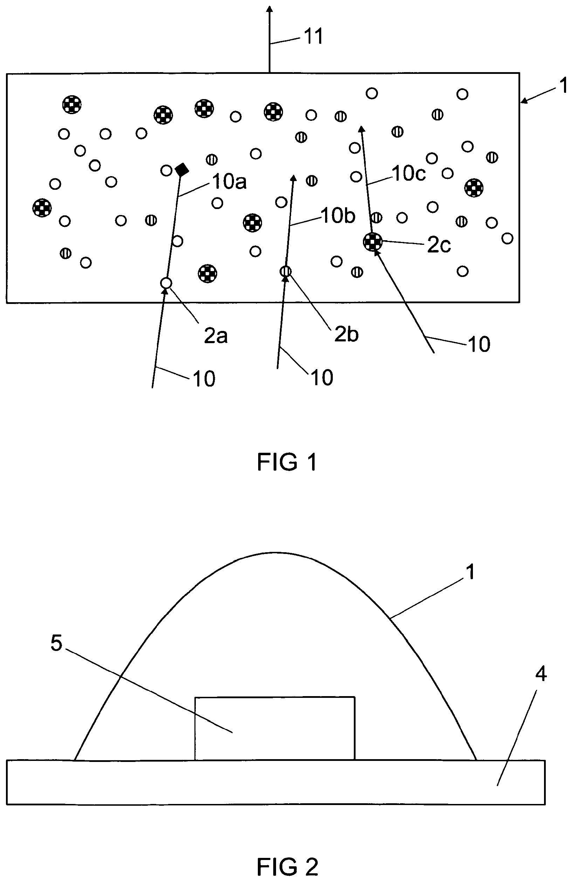

In der schematischen Schnittdarstellung der Figur 1 ist ein hier beschriebenes Konversionselement 1 schematisch dargestellt. Das Konversionselement 1 umfasst ein Matrixmaterial 3, das beispielsweise mit einem Silikon gebildet ist. In einem Temperaturbereich von beispielsweise wenigstens 25 °C bis höchstens 150 °C sinkt der optische Brechungsindex des Matrixmaterials 3 mit steigender Temperatur ab.

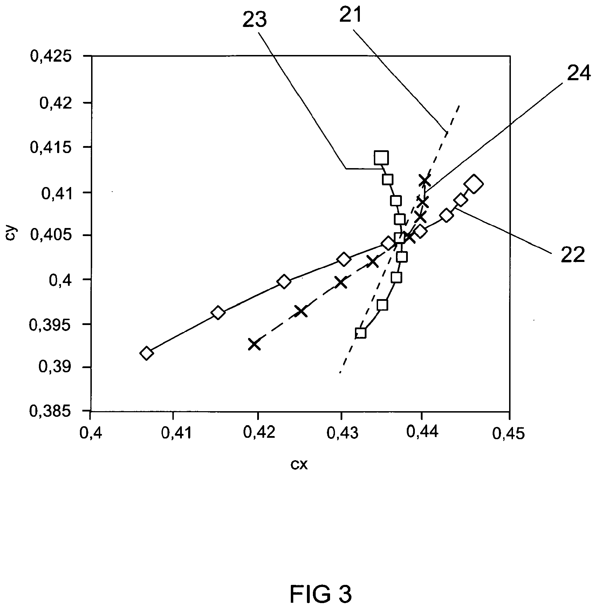

In das Matrixmaterial 3 sind eine Vielzahl von Leuchtstoffpartikeln eingebracht. Dabei sind in das Matrixmaterial 3 im Ausführungsbeispiel der Figur 3 drei unterschiedliche Arten von Leuchtstoffpartikeln in das Matrixmaterial 3 eingebracht. Beispielsweise umfasst das Konversionselement 1 die folgenden Arten von Leuchtstoffpartikeln: Leuchtstoffpartikel erster Art 2a, die mit LuAGaG:Ce gebildet sind, Leuchtstoffpartikel zweiter Art 2b, die mit (Sr,Ca,Ba)₂Si₅N₈ gebildet sind, und Leuchtstoffpartikel dritter Art 2c, die mit CaAlSiN gebildet sind.

Elektromagnetische Strahlung 10 aus einem ersten Wellenlängenbereich, die in das Konversionselement 1 eintritt, wird teilweise von den Leuchtstoffpartikeln wellenlängenkonvertiert, wobei elektromagnetische Strahlung aus einem zweiten Wellenlängenbereich 10a, 10b, 10c erzeugt wird. Diese mischt sich mit der elektromagnetischen Strahlung aus dem ersten Wellenlängenbereich 10 zu Mischstrahlung 11, bei der es sich beispielsweise um weißes Licht handeln kann. Die Leuchtstoffpartikel erster Art 2a emittieren vorliegend grünes Licht 10a, die Leuchtstoffpartikel zweiter Art 2b emittieren rotes Licht 10b und die Leuchtstoffpartikel dritter Art 2c emittieren ebenfalls rotes Licht 10c. Die Leuchtstoffpartikel zweiter Art und dritter Art sind vorliegend aus unterschiedlichen Materialien gebildet, haben jedoch eine ähnliche Emissionswellenlänge, das heißt das Maximum der Emissionswellenlänge beider Arten von Leuchtstoffpartikeln unterscheidet sich um weniger als 50 nm.

In Verbindung mit Figur 3 sind Farborte für unterschiedliche Konversionselemente bei unterschiedlichen Temperaturen des Matrixmaterials aufgetragen.

Der Startpunkt ist bei 25 °C gewählt und in der grafischen Auftragung der Figur 3 durch die dicken Symbole der Kurven 22, 23 und 24 dargestellt. Gestrichelt ist in die Figur 3 die Judd'sche Gerade 21 eingetragen.

Die Kurve 22 betrifft eine erste Leuchtstoffmischung mit folgenden Leuchtstoffen: (Sr,Ca,Ba) ₂Si₅N₈, LuAGaG:Ce. Die Kurve 23 betrifft eine zweite Leuchtstoffmischung mit folgenden Leuchtstoffen: LuAGaG:Ce, CaAlSiN. Die Kurve 24 betrifft eine dritte Leuchtstoffmischung mit folgenden Leuchtstoffen LuAGaG:Ce, CaAlSiN, (Sr,Ca,Ba)₂Si₅N₈, also den Leuchtstoffen der ersten und der zweiten Leuchtstoffmischung. Die beiden Rotleuchtstoffe sind in der letztgenannten Leuchtstoffmischung zum Beispiel in einem Verhältnis 1:1 eingebracht.

Die einzelnen Messpunkte der Kurven 22, 23 und 24 sind dabei jeweils um 25 °C voneinander entfernt. Die Konzentrationen der einzelnen Leuchtstoffpartikel sind dabei derart eingestellt, dass bei zirka 125 °C von sämtlichen Leuchtstoffmischungen in etwa der gleiche Farbort erreicht wird. Die Kurve 21 stellt die Judd'sche Gerade für 3000 K dar, die die Farborte mit identischer ähnlichster Farbtemperatur zeigt. Diese Linie ist gleichzeitig die Hauptachse einer McAdams-Ellipse. Eine Farbortänderung entlang dieser Linie ist für das menschliche Auge kaum wahrnehmbar. Wird eine Mischung von Leuchtstoffen mit den drei genannten Arten von Leuchtstoffpartikeln, Kurve 24, verwendet, wobei die Rotleuchtstoffe in einer Mischung von in etwa 1:1 vorliegen, so verläuft der Farbort des Mischlichts, 11, im Bereich zwischen 25 °C und 150 °C in etwa entlang der Judd'schen Gerade 21.

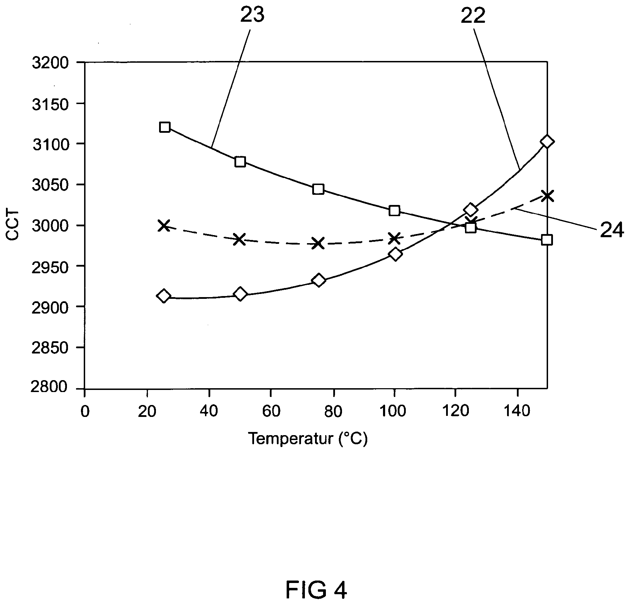

Die Figur 4 zeigt eine grafische Auftragung, in der für die drei Leuchtstoffmischungen die Farbtemperatur in Abhängigkeit von der Temperatur des Matrixmaterials aufgetragen ist. Aus dieser Darstellung ist erkennbar, dass die Variation der Farbtemperatur zwischen 25 °C und 150 °C für die Kurve 24 weniger als 50 K beträgt.

In der schematischen Schnittdarstellung der Figur 2 ist eine Leuchtdiode mit einem hier beschriebenen Konversionselement 1 dargestellt. Die Leuchtdiode umfasst einen Träger 4, bei dem es sich beispielsweise um einen Anschlussträger wie einen Leiterrahmen oder eine Leiterplatte handelt, auf der ein blaues Licht emittierender Leuchtdiodenchip 5 aufgebracht ist. Der Leuchtdiodenchip 5 ist formschlüssig vom Konversionselement 1 umhüllt, beispielsweise mit diesem vergossen.

Die Erfindung ist nicht durch die Beschreibung anhand der Ausführungsbeispiele auf diese beschränkt. Vielmehr umfasst die Erfindung jedes neue Merkmal sowie jede Kombination von Merkmalen in den Patentansprüchen beinhaltet.

## Patentansprüche

1. Konversionselement (1) für die Wellenlängenkonversion von elektromagnetischer Strahlung aus einem ersten Wellenlängenbereich (10) zu elektromagnetischer Strahlung aus einem zweiten Wellenlängenbereich (10a, 10b, 10c), der größere Wellenlängen als der erste Wellenlängenbereich umfasst, mit
- einem Matrixmaterial (3), dessen optischer Brechungsindex temperaturabhängig ist, und
- zumindest zwei unterschiedlichen Arten von Leuchtstoffpartikeln (2a, 2b, 2c), wobei
- eine Vielzahl von Leuchtstoffpartikeln (2a, 2b, 2c) einer jeder der Arten im Matrixmaterial (3) verteilt ist,
- Leuchtstoffpartikel (2a, 2b, 2c)unterschiedlicher Arten sich durch mittlere Partikelgröße und/oder Material voneinander unterscheiden, wobei
- das Konversionselement (1) bei Anregung durch elektromagnetische Strahlung aus dem ersten Wellenlängenbereich (10) Mischstrahlung (11) mit elektromagnetischer Strahlung aus dem ersten (10) und dem zweiten Wellenlängenbereich (10a, 10b, 10c) emittiert, und
- die korrelierte Farbtemperatur und/oder der Farbort der Mischstrahlung (11) bei einer Temperatur des Matrixmaterials (3) zwischen wenigstens 25 °C und höchstens 150 °C im Wesentlichen gleich bleiben,
wobei mit steigender Temperatur
- die temperaturabhängige Verschiebung der von einem optoelektronischen Bauelement (5) erzeugten elektromagnetischen Strahlung aus dem ersten Wellenlängenbereich (10),
- die Temperaturabhängigkeit der Quanteneffizienz der Leuchtstoff-Konversion und
- die Temperaturabhängigkeit der Leuchtstoffabsorption zu einer Farbortverschiebung in Richtung der elektromagnetischen Strahlung aus dem ersten Wellenlängenbereich (10) führen und
- die Brechungsindexänderung des Matrixmaterials (3) des Konversionselements (1) eine teilweise Kompensation dieser Farbortverschiebung bewirkt,
wobei bei einer ersten Art von Leuchtstoff die Kompensation der Verschiebung hin zu elektromagnetischer Strahlung aus dem ersten Wellenlängenbereich (10) für ein Gleichbleiben des Farborts zu gering ausfällt und bei einer zweiten Art von Leuchtstoffen für Partikel (2a, 2b, 2c) dieses Leuchtstoffes eine Überkompensation auftritt, d.h. sich die Mischstrahlung in Richtung der elektromagnetischen Strahlung aus dem zweiten Wellenlängenbereich (10a, 10b, 10c) verschiebt, **dadurch gekennzeichnet, dass** bei dem Konversionselement die korrelierte Farbtemperatur der Mischstrahlung bei einer Temperatur des Matrixmaterials (3) zwischen wenigstens 25 °C und höchstens 150 °C um höchstens 60 K variiert.

2. Konversionselement (1) nach einem der vorherigen Ansprüche,
bei dem der Farbort der Mischstrahlung (11) bei einer Temperatur des Matrixmaterials (3) zwischen wenigstens 25 °C und höchstens 150 °C innerhalb einer Drei-Step-McAdam-Ellipse liegt.

3. Konversionselement (1) nach einem der vorherigen Ansprüche,
bei dem der Brechungsindex des Matrixmaterials (3) mit steigender Temperatur im Temperaturbereich zwischen wenigstens 25 °C und höchstens 150 °C sinkt.

4. Konversionselement (1) nach einem der vorherigen Ansprüche,
bei dem das Matrixmaterial (3) im Wesentlichen frei von Partikeln eines Streumaterials ist.

5. Konversionselement (1) nach einem der vorherigen Ansprüche mit drei Arten von Leuchtstoffpartikeln (2a, 2b, 2c), wobei zwei Arten von Leuchtstoffpartikeln einen gleichen oder einen ähnlichen ersten Emissionswellenlängenbereich aufweisen und die dritte Art von Leuchtstoffpartikeln einen weiteren Emissionswellenlängenbereich aufweist, dessen Maximum vom Maximum des ersten Emissionswellenlängenbereichs um wenigstens 100 nm abweicht.

6. Konversionselement (1) nach einem der vorherigen Ansprüche,
bei dem die Leuchtstoffpartikel (2a, 2b, 2c) von zumindest zwei der unterschiedlichen Arten aus unterschiedlichen Materialen bestehen und einen ähnlichen Emissionswellenlängenbereich aufweisen.

7. Konversionselement (1) nach Anspruch 5 oder 6
mit Leuchtstoffpartikeln (2a, 2b, 2c) aus LuAGAG:Ce, Leuchtstoffpartikeln aus (Sr,Ca,Ba)₂Si₅N₈ und Leuchtstoffpartikeln aus CaAlSiN.

8. Konversionselement (1) nach einem der Ansprüche 1 bis 5,
bei dem die Leuchtstoffpartikel (2a, 2b, 2c) von zumindest zwei der unterschiedlichen Arten aus dem gleichen Material bestehen und unterschiedliche mittlere Partikelgrößen aufweisen.

9. Leuchtdiode mit
- einem Leuchtdiodenchip (5), der im Betrieb elektromagnetische Strahlung aus dem ersten Wellenlängenbereich (10) emittiert, und
- einem Konversionselement (1) nach einem der vorherigen Ansprüche, wobei
- das Konversionselement (1) dem Leuchtdiodenchip (4) derart nachgeordnet ist, dass zumindest ein Teil der elektromagnetischen Strahlung aus dem ersten Wellenlängenbereich in das Konversionselement (1) tritt und zu elektromagnetischer Strahlung aus dem zweiten Wellenlängenbereich (10a, 10b, 10c) konvertiert wird.

10. Leuchtdioden nach dem vorherigen Anspruch,
bei der das Konversionselement (1) den Leuchtdiodenchip (4) formschlüssig umhüllt.

## Claims

1. Conversion element (1) for the wavelength conversion of electromagnetic radiation from a first wavelength range (10) to electromagnetic radiation from a second wavelength range (10a, 10b, 10c), which comprises longer wavelengths than the first wavelength range, comprising
- a matrix material (3), the optical refractive index of which is temperature-dependent, and
- at least two different types of luminophore particles (2a, 2b, 2c) wherein
- a multiplicity of luminophore particles (2a, 2b, 2c) of each of the types are distributed in the matrix material (3),
- luminophore particles (2a, 2b, 2c) of different types differ from one another in terms of average particle size and/or material, wherein
- the conversion element (1), upon excitation by electromagnetic radiation from the first wavelength range (10) emits mixed radiation (11) comprising electromagnetic radiation from the first (10) and the second wavelength range (10a, 10b, 10c), and
- the correlated colour temperature and/or the colour locus of the mixed radiation (11) remain(s) substantially the same when the matrix material (3) is at a temperature of between at least 25°C and at most 150°C,
wherein, as the temperature rises,
- the temperature-dependent shift of the electromagnetic radiation from the first wavelength range (10) generated by an optoelectronic component (5),
- the temperature dependence of the quantum efficiency of the luminophore conversion and
- the temperature dependence of the luminophore absorption
lead to a colour locus shift in the direction of the electromagnetic radiation from the first wavelength range (10), and
- the change in refractive index of the matrix material (3) of the conversion element (1) brings about a partial compensation of this colour locus shift,
wherein, in the case of a first type of luminophore, the compensation of the shift towards electromagnetic radiation from the first wavelength range (10) turns out to be too small for the colour locus to remain the same, and, in the case of a second type of luminophores, an overcompensation occurs for particles (2a, 2b, 2c) of this luminophore, that is to say that the mixed radiation shifts in the direction of the electromagnetic radiation from the second wavelength range (10a, 10b, 10c),
**characterized in that** in the conversion element the correlated colour temperature of the mixed radiation varies by at most 60 K when the matrix material (3) is at a temperature of between at least 25°C and at most 150°C.

2. Conversion element (1) according to the preceding claim,
wherein the colour locus of the mixed radiation (11) lies within a three-step McAdam ellipse when the matrix material (3) is at a temperature of between at least 25°C and at most 150°C.

3. Conversion element (1) according to either of the preceding claims,
wherein the refractive index of the matrix material (3) decreases with rising temperature in the temperature range of between at least 25°C and at most 150°C.

4. Conversion element (1) according to any of the preceding claims,
wherein the matrix material (3) is substantially free of particles of a scattering material.

5. Conversion element (1) according to any of the preceding claims comprising three types of luminophore particles (2a, 2b, 2c), wherein two types of luminophore particles have an identical or a similar first emission wavelength range and the third type of luminophore particles has a further emission wavelength range, the maximum of which deviates from the maximum of the first emission wavelength range by at least 100 nm.

6. Conversion element (1) according to any of the preceding claims,
wherein the luminophore particles (2a, 2b, 2c) of at least two of the different types consist of different materials and have a similar emission wavelength range.

7. Conversion element (1) according to Claim 5 or 6 comprising luminophore particles (2a, 2b, 2c) composed of LuAGaG:Ce, luminophore particles composed of (Sr,Ca,Ba)₂Si₅N₈ and luminophore particles composed of CaAlSiN.

8. Conversion element (1) according to any of Claims 1 to 5, wherein the luminophore particles (2a, 2b, 2c) of at least two of the different types consist of the same material and have different average particle sizes.

9. Light-emitting diode comprising
- a light-emitting diode chip (5), which emits electromagnetic radiation from the first wavelength range (10) during operation, and
- a conversion element (1) according to any of the preceding claims, wherein
- the conversion element (1) is disposed downstream of the light-emitting diode chip (5) in such a way that at least part of the electromagnetic radiation from the first wavelength range passes into the conversion element (1) and is converted to electromagnetic radiation from the second wavelength range (10a, 10b, 10c).

10. Light-emitting diode according to the preceding claim, wherein the conversion element (1) envelops the light-emitting diode chip (5) in a positively locking manner.

## Revendications

1. Élément de conversion (1) pour la conversion de longueur d'onde d'un rayonnement électromagnétique issu d'une première plage de longueurs d'onde (10) en un rayonnement électromagnétique issu d'une deuxième plage de longueurs d'onde (10a, 10b, 10c), qui comprend des longueurs d'onde supérieures à celles de la première plage de longueurs d'onde, avec :
- un matériau de matrice (3) dont l'indice de réfraction optique est fonction de la température et
- au moins deux types différents de particules de matière luminescente (2a, 2b, 2c),
- une pluralité de particules de matière luminescente (2a, 2b, 2c) de chaque type étant répartie dans le matériau de matrice (3),
- des particules de matière luminescente (2a, 2b, 2c) de différents types se distinguant l'une de l'autre par la taille moyenne des particules et/ou la matière,
- l'élément de conversion (1) émettant, lorsqu'il est excité par un rayonnement électromagnétique issu de la première plage de longueurs d'onde (10), un rayonnement mixte (11) composé de rayonnements électromagnétiques issu des première (10) et deuxième plages de longueurs d'onde (10a, 10b, 10c) et
- la température chromatique corrélée et/ou la chromaticité du rayonnement mixte (11) restent sensiblement constantes à une température du matériau de matrice (3) comprise entre 25 °C au minimum et 150 °C au maximum,
à mesure que la température augmente :
- le décalage fonction de la température du rayonnement électromagnétique généré par un composant optoélectronique (5) et issu de la première plage de longueurs d'onde (10),
- la dépendance thermique de l'efficacité quantique de la conversion de la matière luminescente et
- la dépendance thermique de l'absorption de matière luminescente entraînant un décalage de chromaticité vers le rayonnement électromagnétique issu de la première plage de longueurs d'onde (10) et
- la modification de l'indice de réfraction du matériau de matrice (3) de l'élément de conversion (1) entraînant une compensation partielle de ce décalage de chromaticité,
la compensation du décalage vers un rayonnement électromagnétique issu de la première plage de longueurs d'onde (10) étant, pour un premier type de matière luminescente, trop faible pour un maintien constant de la chromaticité et, pour un deuxième type de matières luminescentes, pour des particules (2a, 2b, 2c) de cette matière luminescente, une surcompensation survenant, c'est-à-dire que le rayonnement mixte se décale vers le rayonnement électromagnétique issu de la deuxième plage de longueurs d'onde (10a, 10b, 10c), **caractérisé en ce que**, pour l'élément de conversion, la température chromatique corrélée du rayonnement mixte varie de 60 K au maximum pour une température du matériau de matrice (3) comprise entre 25 °C au minimum et 150 °C au maximum.

2. Élément de conversion (1) selon l'une des revendications précédentes, selon lequel la chromaticité du rayonnement mixte (11) se situe dans une ellipse de MacAdam de niveau 3 à une température du matériau de matrice (3) comprise entre 25 °c au minimum et 150 °c au maximum.

3. Élément de conversion (1) selon l'une des revendications précédentes, selon lequel l'indice de réfraction du matériau de matrice (3) tombe à mesure que la température augmente dans la plage de température comprise entre 25 °C au minimum et 150 °C au maximum.

4. Élément de conversion (1) selon l'une des revendications précédentes, selon lequel le matériau de matrice (3) est sensiblement exempt de particules d'un matériau à répandre.

5. Élément de conversion (1) selon l'une des revendications précédentes, comportant trois types de particules de matière luminescente (2a, 2b, 2c), deux types de particules de matière luminescente présentant une première plage d'émission de longueurs d'onde identique ou similaire et le troisième type de particules de matière luminescente présentant une autre plage d'émission de longueurs d'onde dont le maximum diffère d'au moins 100 nm du maximum de la première plage d'émission de longueurs d'onde.

6. Élément de conversion (1) selon l'une des revendications précédentes, selon lequel les particules de matière luminescente (2a, 2b, 2c) d'au moins deux des différents types se composent de matières différentes et présentent une plage d'émission de longueurs d'onde similaire.

7. Élément de conversion (1) selon la revendication 5 ou 6, comportant des particules de matière luminescente (2a, 2b, 2c) composées de LuAGAG:Ce, des particules de matière luminescente composées de (Sr,Ca,Ba)₂Si₅N₈ et des particules de matière luminescente composées de CaAlSiN.

8. Élément de conversion (1) selon l'une des revendications 1 à 5, selon lequel les particules de matière luminescente (2a, 2b, 2c) d'au moins deux des différents types se composent de la même matière et présentent des tailles moyennes différentes.

9. Diode électroluminescente comportant :
- une puce de diode électroluminescente (5) qui émet, en service, un rayonnement électromagnétique issu de la première plage de longueurs d'onde (10) et
- un élément de conversion (1) selon l'une des revendications précédentes,
- l'élément de conversion (1) étant situé en aval de la puce de diode électroluminescente (4) de telle sorte qu'au moins une partie du rayonnement électromagnétique issu de la première plage de longueurs d'onde entre dans l'élément de conversion (1) et est convertie en rayonnement électromagnétique issu de la deuxième plage de longueurs d'onde (10a, 10b, 10c).

10. Diode électroluminescente selon la revendication précédente, selon laquelle l'élément de conversion (1) entoure la puce de diode électroluminescente (4) avec complémentarité de forme.
